Europäisches Patentamt

European Patent Office

Office européen des brevets

(11) Publication number: **0 634 838 A1**

## EUROPEAN PATENT APPLICATION

(21) Application number: **94109092.0**

(22) Date of filing: **14.06.94**

(51) Int. Cl.6: **H03K 17/16**, H03K 17/687, H03K 17/08

(30) Priority: **15.06.93 DE 4319816**

(43) Date of publication of application:
**18.01.95 Bulletin 95/03**

(84) Designated Contracting States:
**DE FR GB IT NL**

(71) Applicant: **TEXAS INSTRUMENTS
DEUTSCHLAND GMBH
Haggertystrasse 1
D-85356 Freising (DE)**

(72) Inventor: **Wagensohner, Konrad
Hochfeldstrasse 26
D-85419 Mauern (DE)**
Inventor: **Bayer, Erich
Am Blankenfeld 15
D-84030 Ergolding (DE)**

(74) Representative: **Schwepfinger, Karl-Heinz,
Dipl.-Ing. et al
Prinz & Partner,
Manzingerweg 7
D-81241 München (DE)**

(54) **Circuit assembly for controlling a MOS field effect transistor push-pull stage.**

(57) A circuit assembly for controlling a push-pull stage comprising two MOS field-effect transistors Q1, Q2 is described. For changeover-switching of the push-pull stage suitable charging and discharging circuits L1, L2, E1, E2 for the gate-source capacitances ($C_{GS1}$, $C_{GS2}$) are provided. Moreover at least one inhibitor circuit Q3, Q4 controlled by the gate voltage $V_{G1}$, $V_{G2}$ of one of the MOS field-effect transistors is provided. By means of this inhibitor circuit charging of the gate-source capacitance $C_{GS1}$, $C_{GS2}$ of the corresponding other MOS field-effect transistor Q1, Q2 operating in push-pull is prevented until the gate voltage $V_{G1}$, $V_{G2}$ has dropped below a definable limit value at which the gate-source capacitance $C_{GS1}$, $C_{GS2}$ of the MOS field-effect transistor monitored as regards its gate voltage $V_{G1}$, $V_{G2}$ has been discharged at least partly, preferably more or less completely.

Fig. 3

The invention relates to a circuit assembly for controlling a push-pull stage comprising at least two metal-oxide semiconductor (MOS) field-effect transistors including connectable charging and discharging circuits by means of which the gate-source capacitances can be charged and discharged according to a corresponding time constant, the value of which is a function of the internal resistance of the corresponding charging and discharge circuit respectively and of the corresponding gate-source capacitance.

Particularly in power output stages it is often a requirement that the corresponding power MOS field-effect transistors need to be switched ON/OFF softly to ensure maintaining the specified maximum permissible values of the rise and fall times of the output voltage or output current.

For this purpose suitable charging and discharge circuits are provided the internal resistance of which together with the associated gate-source capacitance determines the ON/OFF time constant., whereby the wanted rate of change of the corresponding gate voltage is normally defined by an ohmic resistance connected in series with the gate-source capacitance or by a current which is impressed on the charging or discharging circuit.

Although controlling MOS field-effect transistors in this way results in the wanted limiting of the rise and fall rates of the output voltage or of the output current in push-pull stages too, whereby the internal resistance of the charging and discharging circuits is to be selected all the more higher, the lower the rate of change of the output signal is required, when the push-pull stages contain two MOS field-effect transistors in series, however, there is a problem that when changing over from one MOS field-effect transistor to the other a current flows through the series circuit containing the two MOS field-effect transistors which can assume relatively high values since in the transitional phase this current is usually limited by the drain-source resistances only of the MOS field-effect transistors which, at least partly, are in forward control. Such an unwanted flow of current will materialize due to both MOS field-effect transistors of the push-pull stage being simultaneously rendered conducting at least partly during the changeover phase. The duration of this critical changeover phase is all the more longer, the smaller the rate of change of the gate voltages is selected to achieve the wanted limited rise and fall times of the output voltage.

In a known controlling circuit the ON command is digitally delayed but the delay time to be set always depends on the MOS field-effect transistors being used, the temperature response of the resistances and the method of fabrication. The digital delay must also be sufficiently long to take into account a possible extreme condition. Accordingly it is always too long for normal conditions. On top of this the digital delay in each case is suitable only for a special combination of power MOS field-effect transistors and controlling circuit. When in a modular system, for instance, the MOS field-effect transistors are replaced by others having a different input capacitance then the digital delay is either too short or too long.

By contrast the object of the invention is based on creating a circuit assembly of the aforementioned kind, which is particularly simple to achieve, that not only limits the rate of change of the output signal of the push-pull stage to a predetermined value but, at the same time, also reliably limits or suppresses the current flowing through the MOS field-effect transistors when a changeover is made from one to the other.

This object is achieved according to the invention by at least one inhibitor circuit being provided which is controlled by the gate voltage of one of the MOS field-effect transistors, this inhibitor circuit preventing charging of the gate-source capacitance of the corresponding other MOS field-effect transistor operating in push-pull until the gate voltage has exceeded a definable limit value at which the gate-source capacitance of the MOS field-effect transistor monitored as regards its gate voltage has been discharged at least partly.

As a result of this configuration a control circuit is created which is exceptionally simple to achieve and which is completely independent of the level of the rate of change of the push-pull output signal definable respectively via the charging and discharging circuit to always ensure a reliable limiting or suppression of the current flowing through the MOS field-effect transistors during the changeover phase. Accordingly, even when the definable rate of change of the output signal of the push-pull stage is small, the possibility of an unwanted current flowing during the correspondingly longer changeover phase from the one MOS field-effect transistor to the other - which could possibly result in the transistors being ruined - is eliminated. Since this current limiting or suppression and the limiting of the rise and fall times of the output signal of the push-pull stage can be made independent of each other the corresponding level of this rate of change is freely adjustable via the corresponding charging and discharging circuits without having to put up with a higher loading of the MOS field-effect transistors.

By this embodiment of the invention the drawbacks as mentioned in conjunction with a digital delay are also eliminated. According to the invention it is always the actual gate voltage that is measured and charging of the gate-source capacitance involved is always prevented as long as this is absolutely necessary.

The maximum permissible current value allowed during the changeover phase is definable via the limit value for the monitored gate voltage. It is basically feasible to allow a further certain current during this transitional phase. However, it is preferable to select the definable limit value for the monitored gate voltage so that the gate source capacitance of the corresponding MOS field-effect transistor is discharged at least substantially when this limit value fails to be achieved, thus practically eliminating any flow of current whatsoever. In this case it is namely assured that a corresponding MOS field-effect transistor of the push-pull stage is not ON until the other MOS field-effect transistor in the push-pull arrangement is practically completely OFF and its drain-source resistance assumes its maximum value.

If the inhibitor circuit is advantageously formed by at least one transistor, particularly a MOS field-effect transistor, it is then useful to to connect its gate electrode to the gate electrode of the MOS field-effect transistor which is monitored as regards its gate voltage and to circuit its drain-source connection between the gate electrode of the other MOS field-effect transistor in the push-pull arrangement and ground applied to one end of the push-pull stage.

In this case the definable limit value for the monitored gate voltage is determined by the threshold value of this transistor forming the inhibitor circuit. As long as this transistor is in the forward condition it is substantially connected to ground by this controlled gate electrode of the corresponding MOS field-effect transistor of the push-pull arrangement thus preventing charging of the gate-source capacitance of this MOS field-effect transistor. Charging of this gate-source capacitance via the assigned charging current circuit is not possible until the transistor forming the inhibitor circuit is in the reverse condition. This, however, will not happen until the the gate voltage of the other MOS field-effect transistor fails to achieve its threshold voltage, i.e. when the gate-source capacitance of the corresponding MOS field-effect transistor of the push-pull stage has been discharged according to the selected threshold value.

In accordance with one particularly advantageous embodiment of the invention each of the push-pull MOS field-effect transistors is assigned an inhibitor circuit to prevent charging of the gate-source capacitance of the other push-pull MOS field-effect transistor in each case as a function of its gate voltage. In this case by providing a separate inhibitor circuit for each changeover direction it is ensured that a corresponding MOS field-effect transistor of the push-pull stage is not switched ON until the drain-source resistance of the other MOS field-effect transistor has attained such a value that the wanted current limiting is assured, whereby it is preferably provided for otherwise that the MOS field-effect transistor concerned is not switched ON until the other MOS field-effect transistor is switched OFF at least substantially so and its drain-source resistance has thus assumed its maximum value.

One advantageous embodiment of the invention which is more or less immune particularly to noise voltages is characterized by an inhibitor circuit being assigned only to the MOS field-effect transistor of the push-pull stage connected between the supply voltage and ground, this MOS field-effect transistor being connected to ground as a low-side driver so that charging of the gate-source capacitance of the other MOS field-effect transistor provided as the high-side driver as a function of its gate voltage is prevented and in that this inhibitor circuit simultaneously forms the discharge circuit of the high-side driver.

In this embodiment there is no need to monitor the gate voltage of the high-side driver thus preventing any noise voltages - which may have entered the circuit, for example, via the output and the gate-source capacitance of the high-side driver - from leading to sensing of an elevated measured gate voltage with respect to ground whilst the gate-source voltage responsible for the switching condition of the high-side driver in actual fact is influenced in the other direction in which the source electrode assumes a higher potential than the gate electrode. Instead, this embodiment ensures that the gate-source capacitance of the high-side driver is first sufficiently discharged via the discharge circuit formed by the inhibitor circuit before the gate-source capacitance of the low-side driver is charged.

For this purpose the threshold voltage of the inhibitor circuit preferably formed by at least one transistor and controlled by the gate voltage of the low-side driver is selected usefully smaller than the threshold voltage of the low-side driver. This arrangement assures that when the gate voltage of the low-side driver increases due to the assigned charging circuit before the threshold voltage of the low-side driver is achieved, the threshold voltage of the inhibitor circuit is first exceeded so that the latter changes to a condition in which it serves as the discharge circuit for the high-side driver.

In this alternative embodiment, characterized by it being particularly immune to noise, the rate of change of the gate voltage of the low-side driver is also preferably selected less than that of the gate voltage of the high-side driver which can be done via the charging/discharging circuits concerned.

The invention takes into account that particularly for a push-pull circuit at a potential between ground and the supply voltage comprising two MOS field-effect transistors connected in series with the output terminal connected inbetween, the high-side driver at the potential of the supply voltage end operates as a source follower and the low-side driver at ground potential operates as a voltage amplifier. From this arrangement it follows that when the high-side driver is switched the rate of change of the output voltage equals the rate of change of the corresponding gate voltage, whilst when the low-side driver is switched the rate of change of the output signal is greater that rate of change of the corresponding gate signal. This difference is compensated by the invention making the rate of change of the two gate voltages different.

To ensure that the rate of change of the output signal and also of the current is limited as required also during the changeover phase in which the inhibitor circuit serves as the discharge circuit for the high-side driver, several requirements need to be satisfied. First of all, the mean charging current must be high enough to discharge the charge held in the gate-source capacitance of the high-side driver to the required degree in the time interval remaining between violation of the lower threshold voltage of the inhibitor circuit - at which this is changed over to the condition of a discharge circuit - and achieving the higher threshold voltage of the low-side driver. In addition, this time interval must be sufficiently long to ensure the desired limiting of the rate of change of the output signal. The minimum duration of this time interval usually depends on the ratio of the maximum output voltage to the maximum rate of change of this voltage. Together with the definable time constant of the charging circuit of the low-side driver the difference between the two threshold voltages of the inhibitor circuit - which is simultaneously a discharge circuit - and of the low-side driver can then be determined. This difference in the threshold voltage is accordingly and particulary a function of both the time constant of the charging circuit of the low-side driver and of the time constant of the discharge circuit formed by the inhibitor circuit.

In accordance with one advantageous embodiment it can thus be provided for that the difference between the two threshold voltages is selected as a function of the time constant of the charging circuit of the low-side driver and of the time constant of the discharge circuit formed by the inhibitor circuit so that the gate-source capacitance of the high-side driver is discharged at least partly as soon as the gate voltage of the low-side driver controlling this inhibitor and discharge circuit respectively has attained the threshold voltage of the low-side driver once the threshold voltage of this inhibitor or discharge circuit has been exceeded. In this respect the difference in the threshold voltage is preferably selected so that the gate-source capacitance of the high-side driver is discharged at least substantially when the threshold voltage of the low-side driver is attained.

To boost the discharge current the inhibitor circuit may usefully contain a Darlington circuit.

Further advantageous embodiments of the invention are stated in the sub-claims.

The invention will now be explained in more detail on the basis of example embodiments with reference to the drawing in which

Fig. 1 is a basic circuit diagram of a conventional push-pull circuit,

Fig. 2 is a voltage-time graph showing the profile of the two input voltages and of the two gate voltages relative to the push-pull stage shown in Fig. 1,

Fig. 3 is a first embodiment of the circuit assembly according to the invention for controlling a push-pull stage comprising two power MOS field-effect transistors,

Fig. 4 is a voltage-time graph of the two input voltages and of the two gate voltages relative to the circuit assembly shown in Fig. 3,

Fig. 5 is a variation on the circuit assembly according to the invention shown in Fig. 3,

Fig. 6 is a second embodiment of the the circuit assembly according to the invention for controlling a push-pull stage comprising two power MOS field-effect transistors, and

Fig. 7 is a variation of the second embodiment of the circuit assembly according to the invention shown in Fig. 6.

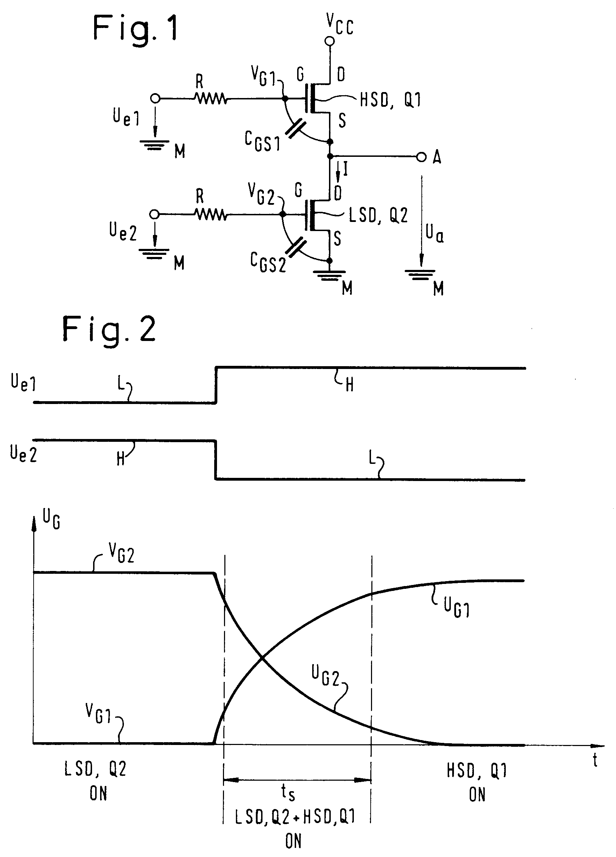

Fig. 1 shows a conventional push-pull stage comprising two power MOS field-effect transistors Q1, Q2 which is controlled by a conventional control circuit.

The two MOS field-effect transistors Q1, Q2 of the push-pull stage are connected in series by their drain-source connections D-S whereby the drain electrode of the MOS field-effect transistor Q1 is connected to the supply voltage $V_{CC}$ and the source electrode of the MOS field-effect transistor Q2 is connected to ground. An output terminal A is connected to the connected-together source and drain electrodes S,D of MOS field-effect transistor Q1 and MOS field-effect transistor Q2 respectively.

In such an arrangement of a power push-pull stage the transistor at the potential of the supply voltage $V_{CC}$ istermed the high-side driver HSD and the transistor at ground potential is termed the low-side driver LSD. Power push-pull stages of this kind may be employed. for example, in so-called H bridges which as a rule are made up of two push-pull stages and are used, for example, as feed circuits for electric motors and the like.

The conventional circuit assembly shown for controlling the push-pull stage includes for each MOS field-effect transistor Q1, Q2 an ohmic resistor R connected to the corresponding gate electrode G at the one end and to the input terminal at the other, to which the input voltage $U_{e1}$, $U_{e2}$ is applied in each case for controlling the corresponding push-pull transistor. The desired limiting of the rate of change of the output voltage $U_a$ is thus achieved by the ohmic resistances R in conjunction with the gate-source capacitance $C_{GS1}$, $C_{GS2}$ assigned in each case, whereby these resistances establish at the same time both the corresponding charging circuits as well as the discharge circuits in each case. The desired limiting of the rate of change of the output voltage $U_a$ may also be attained - instead of by means of the ohmic resistors R - by impressing a current to each of the charging and discharging circuits for the gate-source capacitances $C_{GS1}$, $C_{GS2}$.

In such a conventional arrangement of controlling the push-pull stage the rise and fall times of the output voltage $U_a$ can be limited to a prescribed value but there is the drawback that when changing over from one MOS field-effect transistor to the other of the push-pull stage an unwanted current is able to flow from the supply voltage terminal $V_{CC}$ through the two MOS field-effect transistors Q1, Q2 directly to ground GND (M), the value of which may be relatively high since both MOS field-effect transistors Q1, Q2 are partly ON and their drain-source resistances are accordingly relatively small.

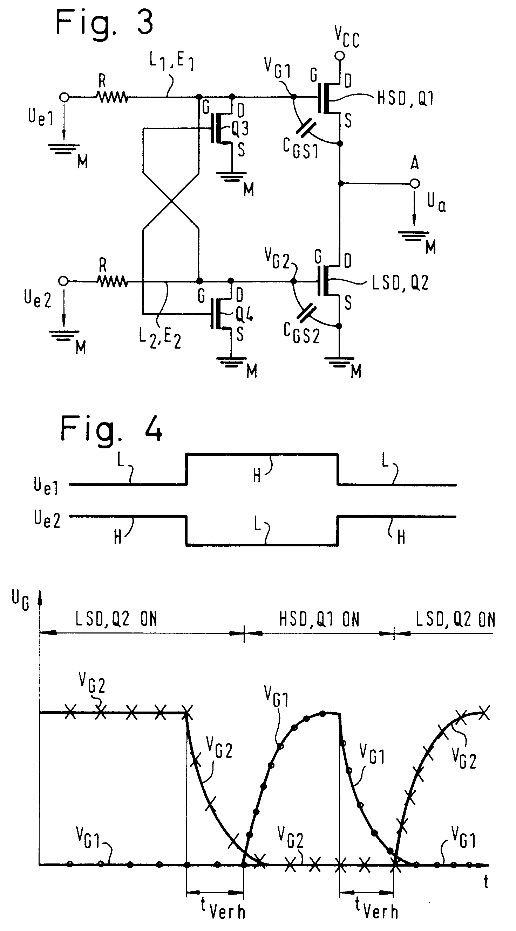

This situation is illustrated in Fig. 2 in which the time profile of the input voltages $U_{e1}$, $U_{e2}$ and of the corresponding gate voltage $V_{G1}$, $V_{G2}$ during the changeover phase is shown.

According to this and for simultaneous controlling of the MOS field-effect transistors Q1, Q2 of the push-pull stage, but in the opposite sense, the corresponding input voltages $U_{e1}$, $U_{e2}$ are controlled in such a way that the input voltage $U_{e1}$ for controlling the MOS field-effect transistor Q1 jumps from a low level L to a high level H and the input voltage $U_{e2}$ for controlling the MOS field-effect transistor Q2 drops from a high level H to a low level L. This simultaneously prompts charging of the gate-source capacitance $C_{GS1}$ via the corresponding resistor R and discharging of the gate-source capacitance $C_{GS2}$ via its corresponding resistor R when assuming a condition in which the high-side driver HSD (Q1) is OFF and the low-side driver LSD (Q2) is ON, Accordingly, the gate voltage $V_{G1}$ of the high-side driver HSD (Q1) increases in keeping with a time constant which mainly depends on the assigned ohmic resistor R and the gate-source capacitance $C_{GS1}$. At the same time the gate voltage $V_{G2}$ of the low-side driver LSD (Q2) drops to a minimum in the vicinity of zero in accordance with a time constant which in turn is determined by the ohmic resistor and gate-source capacitance $C_{GS2}$ concerned. In the end the high-side driver HSD (Q1) is ON whilst the low-side driver LSD (Q2) is OFF.

As can be seen from the curves depicting the gate voltages $V_{G1}$, $V_{G2}$ the two MOS field-effect transistors Q1, Q2 are each controlled according to the definable time constants but during the changeover phase $t_S$ both transistors are ON at least partly so that a current I flows from the supply voltage terminal $V_{CC}$ via the two transistors Q1, Q2 directly to ground GND (M) - viz. Fig. 1. On top of this the duration of this critical transitional phase depends on the time constant in each case of the charging or dischrging circuit. If, for instance, the changeover of the two transistors is to be delayed as strongly as possible then the duration of the critical changeover phase $t_S$ whilst both transistors are in the forward condition at least partly is also relatively high.

In Fig. 3 a first embodiment of the circuit assembly according to the invention for controlling a push-pull stage comprising two power MOS field-effect transistors Q1, Q2 is shown in which the aforementioned drawbacks are eliminated.

The two power MOS field-effect transistors Q1, Q2 of the push-pull stage are in turn connected in series by their drain-source connections D-S. The drain electrode D of the MOS field-effect transistor Q1 has the potential of the supply voltage $V_{CC}$ whilst its source electrode S is connected to the drain electrode D of the other MOS field-effect transistor Q2, the source electrode S of which is in turn at ground potential GND (M). The output terminal A may in turn be connected to the source electrode of the MOS field-effect transistor Q1 and to the drain electrode D of the MOS field-effect transistor Q2. The two power MOS field-effect transistors Q1, Q2 may usefully be formed each by a DMOS field-effect transistor. On top of this one such push-pull stage may be employed for instance in an H bridge containing two such push-pull stages and used, for example, to feed an electric motor and the like. In conclusion, in the arrangement of the push-pull stage as shown, the MOS field-effect transistor Q1 at the potential of the supply voltage $V_{CC}$ can again be termed the high-side driver HSD (Q1) and the MOS field-effect transistor Q2 at ground potential GND (M) is again the low-side driver LSD (Q2).

To control the push-pull stage its high-side driver HSD (Q1) and its low-side driver LSD (Q2) are assigned a charging circuit L1, L2 and a discharge circuit E1, E2 respectively, whereby the charging and discharging circuits L1, E1 and L2, E2 respectively assigned to the corresponding MOS field-effect transistors Q1, Q2 are each formed by a common resistor R which at the one end is connected to the gate electrode G of the corresponding transistor Q1, Q2 and at the other to an input terminal to which the associated input voltage $U_{e1}$, $U_{e2}$ is applied to control the transistor Q1, Q2 concerned. By this arrangement the gate-source capacitances $C_{GS1}$, $C_{GS2}$ of the high-side driver HSD (Q1) and of the low-side driver LSD (Q2) respectively can each be charged via the assigned resistor R and discharged via the same resistor. The time constants in each case are determined at least substantially by this resistor and by the corresponding gate-source capacitance.

In addition an inhibitor circuit is provided, formed for example by a MOS field-effect transistor Q3 which is controlled by the gate voltage $V_{G2}$ of the low-side driver LSD (Q2). This inhibitor circuit prevents charging of the gate-source capacitance $C_{GS1}$ of the high-side driver HSD (Q1) until the gate voltage $V_{G2}$ of the low-side driver LSD (Q2) has dropped below a definable limit value at which the gate-source capacitance $C_{GS2}$ of the low-side driver LSD (Q2) is discharged at least partly, preferably more or less completely. In the example embodiment shown the MOS field-effect transistor Q3 provided for this purpose is connected via its gate electrode G to the gate electrode G of the low-side driver LSD (Q2) and via its drain electrode D to the gate electrode G of the high-side driver HSD (Q1) whilst its source electrode S is at ground potential GND (M)

Correspondingly an inhibitor circuit is also provided which is formed by a MOS field-effect transistor Q4 and controlled by the gate voltage $V_{G1}$ of the high-side driver HSD (Q1) in the example embodiment as shown. This inhibitor circuit prevents charging of the gate-source capacitance $C_{GS2}$ of the low-side driver LSD (Q2) until the gate voltage $V_{G1}$ of the high-side driver HSD (Q1) has dropped below a definable limit value at which the gate-source capacitance $C_{GS1}$ of the high-side driver HSD (Q1) is discharged at least partly, preferably more or less completely. For this purpose the gate electrode G of the MOS field-effect transistor Q4 is connected to to the gate electrode G of the high-side driver HSD (Q1) and via its drain electrode D to the gate electrode G of the low-side driver LSD (Q2) whilst its source electrode S is at ground potential GND (M).

In the example embodiment shown the limit value definable in each case is determined by the threshold voltage of the MOS field-effect transistor Q3 and Q4 respectively.

The way in which the embodiment of the circuit assembly according to the invention as shown in Fig. 3 functions will now be explained with reference to Fig. 4 which in turn shows the time profile of the input voltages $U_{e1}$, $U_{e2}$ for controlling the high-side driver HSD (Q1) and the low-side driver LSD (Q2) respectively of the power push-pull stage together with the gate voltages $V_{G1}$, $V_{G2}$ of these MOS field-effect transistors Q1, Q2.

It is first assumed that the high-side driver HSD (Q1) is OFF and the low-side driver LSD (Q2) is ON. Then, in the example embodiment shown the gate-source capacitance $C_{GS1}$ of the MOS field-effect transistor Q1 is discharged and the gate-source capacitance $C_{GS2}$ of the low-side driver LSD (Q2) is charged. Since the gate voltage $V_{G2}$ of the low-side driver LSD (Q2) exhibits its maximum value the MOS field-effect transistor Q3 forming the one inhibitor circuit has forward control so that the gate electrode G of the high-side driver HSD (Q1) is at ground potential via this transistor Q3. By contrast the MOS field-effect transistor Q4 forming the other inhibitor circuit has reverse control due to the low potential of the gate voltage VG1 of the high-side driver HSD (Q1).

For a changeover of the push-pull stage the input voltage $U_{e1}$ for controlling the high-side driver HSD (Q1) is then made to jump from a low level L to a high level H. At the same time the input voltage $U_{e2}$ for controlling the low-side driver LSD (Q2) is caused to drop from a high level H to a low level L.

Since MOS field-effect transistor Q4 is initially reversed it will first have no effect on the charging and discharging actions. The gate-source capacitance $C_{GS2}$ is discharged according to a time constant which is determined by the corresponding ohmic resistor R and the gate-source capacitance $C_{GS2}$.

As compared to this, charging of the gate-source capacitance $C_{GS1}$ of the high-side driver HSD (Q1) is initially prevented by the MOS field-effect transistor Q3 being ON. This gate-source capacitance $C_{GS1}$ can then not be charged via the assigned ohmic resistor R1 until the MOS field-effect transistor Q3 is reversed, i.e. returned OFF. This can only happen when the gate voltage $V_{G2}$ of the low-side driver LSD (Q2) has dropped below the threshold voltage of the MOS field-effect transistor Q3, i.e. the gate-source capacitance $C_{GS2}$ of the low-side driver LSD (Q2) has been discharged at least partly, preferably more or less completely.

In this arrangement the degree of discharge at which the MOS field-effect transistor Q3 is returned OFF can be determined by a corresponding threshold voltage of this MOS field-effect transistor Q3 or by a corresponding transistor selection.

Accordingly the gate-source capacitance $C_{GS1}$ of the high-side driver HSD (Q1) is not charged until timeout of a definable prevention time $T_{Verh}$ selected so that the current flowing from the supply voltage $V_{CC}$ via the series arrangement of the MOS field-effect transistors Q1, Q2 directly to ground GND (M) during the changeover phase is limited to the still permissible value.

After changeover the high-side driver HSD (Q1) is ON and the low-side driver LSD (Q2) is OFF.

When a further changeover is made from this condition charging of the gate-source capacitance $C_{GS2}$ of the low-side driver LSD (Q2) is suitably prevented by the MOS field-effect transistor Q4 controlled by the gate voltage $V_{G1}$ of the high-side driver HSD (Q1) as long as the gate-source capacitance $C_{GS1}$ of the high-side driver HSD (Q1) is discharged at least partly, preferably more or less completely. Accordingly charging of the gate-source capacitance $C_{GS2}$ of the low-side driver LSD (Q2) is delayed in turn by a time constant corresponding to a prevention time $t_{Verh}$ definable via the threshold voltage of the inhibitor circuit or MOS field-effect transistor Q4 concerned, this time constant being determined by the ohmic resistor R concerned and the gate-source capacitance $C_{GS2}$ . In conclusion the push-pull stage is returned to the condition in which the high-side driver HSD (Q1) is OFF and the low-side driver LSD (Q2) is ON.

In the circuit assembly according to the invention the actual gate voltages $V_{G1}$, $V_{G2}$ of the MOS field-effect transistors Q1, Q2 of the push-pull stage are thus continuously monitored so that charging of the gate-source capacitance $C_{GS1}$ , $C_{GS2}$ concerned in each case is prevented only as long this is absolutely necessary. In addition the timing of the charging and discharging actions as definable by a corresponding time constant is in no way influenced by the inhibitor circuits so that the rate of change of the gate voltages of the MOS field-effect transistors of the push-pull stage and thus of the output signal can be maintained with no problem, as required in each case. Instead of the ohmic resistors R shown in Fig. 3 constant current sources could be provided, for example.

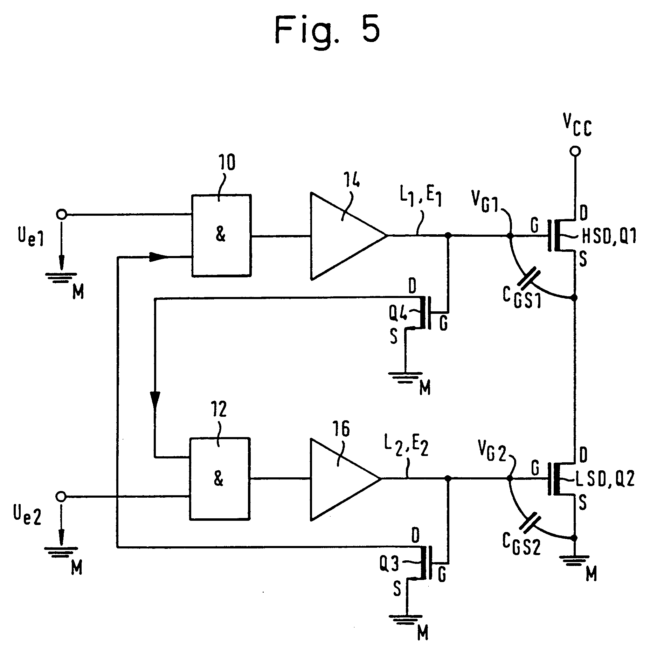

In Fig. 5 another version of the embodiment shown in Fig. 4 is illustrated, identical parts being identified by the same reference numerals.

The circuit assembly of Fig. 5 mainly differs from that shown in Fig. 3 merely by the corresponding gate electrodes no longer being directly grounded via the inhibitor circuits to temporarily prevent charging of the gate-source capacitance $C_{GS1}$ , $C_{GS2}$ of the high-side driver HSD (Q1) and the low-side driver LSD (Q2) respectively. Instead a prevention signal is fed back to the driver logic for the push-pull stage via the inhibitor circuits which in turn prevents a corresponding gate-source capacitance $C_{GS1}$ , $C_{GS2}$ being charged prematurely.

For this purpose the arrangement shown in the purely schematic representation of Fig 5 provides for the drain electrode D of the MOS field-effect transistor Q3 forming the one inhibitor circuit being fed back to an input of an AND gate 10 assigned to the driver logic for the high-side driver HSD (Q1), the other input of which receives the input voltage $U_{e1}$ .

Accordingly the drain electrode D of the MOS Q4 forming the other inhibitor circuit is fed back to to an input of an AND gate 12 assigned to the driver logic for the low-side driver LSD (Q2), the other input of which receives the input voltage $U_{e2}$ . The two AND gates 10, 12 are each followed by an amplifier 14 and 16 respectively.

If for instance according to the function sequence as depicted in Fig. 4 the high-side driver HSD (Q1) is to be turned ON by changing the level of the input voltage $U_{e1}$ applied to one input of the AND gate 10 from low L to high H, transfer of this input control signal to the amplifier 14 is prevented until a high level is also available at the other input of the AND gate 10. This is only the case when the gate voltage VG2 of the low-side driver LSD (Q2) has dropped below the threshold voltage of the MOS field-effect transistor Q3 or the gate-source capacitance $C_{GS2}$ has been discharged at least partly, preferably more or less completely. It is not until then that the gate-source capacitance $C_{GS1}$ of the high-side driver HSD (Q1) can be charged in accordance with the time constant of the charging circuit L1.

In the same way, after a change of the input signal $U_{e2}$ from a low level L to a high level H, the gate-source capacitance $C_{GS2}$ of the low-side driver LSD (Q2) can only be charged via the amplifier 16 or via the charging circuit L2 containing this amplifier when a high level also exists at the second input of the AND gate 12, this only being the case when the gate voltage $V_{G1}$ of the high-side driver HSD (Q1) has dropped below the threshold voltage of the MOS field-effect transistor Q4 forming the other inhibitor circuit or the gate-source capacitance $C_{GS1}$ has been discharged at least partly, preferably more or less completely.

Otherwise the way in which this circuit assembly functions is the same as in the other variant of the embodiment shown in Fig. 3.

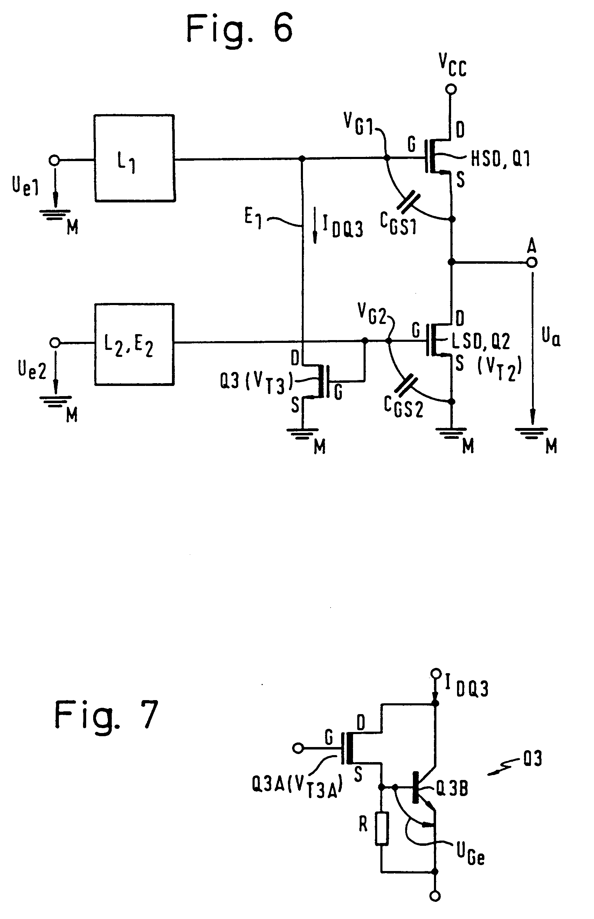

Fig. 6 shows an alternative embodiment of the circuit assembly according to the invention for controlling a power push-pull stage which is particularly characterized by its low susceptibility to noise. Here again identical elements are identified by the same reference numerals.

This alternative embodiment differs from that shown in Fig. 3 mainly by the means of monitoring the gate voltage $V_{G1}$ of the high-side driver HSD (Q1) of the push-pull stage being dispensed with and instead of employing two inhibitor circuits only one is provided, in turn formed by a MOS field-effect transistor Q3 which simultaneously serves as the discharge circuit E1 for the gate-source capacitance $C_{GS1}$ of the high-side driver HSD (Q1).

This inhibitor circuit formed by the MOS field-effect transistor Q3 is controlled by the gate voltage $V_{G2}$ of the low-side driver LSD (Q2) of the power push-pull stage to prevent charging of the gate-source capacitance $C_{GS1}$ of the high-side driver HSD (Q1) until the gate voltage $V_{G2}$ of the low-side driver LSD (Q2) has dropped below the threshold voltage of the MOS field-effect transistor Q3 or the gate-source capacitance $C_{GS2}$ of the low-side driver LSD (Q2) is discharged at least partly, preferably more or less completely. As regards this delayed ON of the high-side driver HSD (Q1) this circuit thus agrees with that shown in Fig. 3.

However, differences exist particularly as regards ON action of the low-side driver LSD (Q2), inhibitor circuit Q3 which simultaneously serves as the discharge circuit E1 for the gate-source capacitance $C_{GS1}$ of the high-side driver HSD (Q1) first making sure that this gate-source capacitance $C_{GS1}$ is adequately discharged before the gate-source capacitance $C_{GS2}$ of the low-side driver LSD (Q2) is charged.

For this purpose the MOS field-effect transistor Q3 - which is connected between the gate electrode G of the high-side driver HSD (Q1) and ground GND (M) by its gate electrode G being connected to the gate electrode G of the low-side driver LSD (Q2) and by its drain-source connection D-S - is at the potential of the threshold voltage $V_{T3}$ which is smaller than the threshold voltage $V_{T2}$ of the low-side driver LSD (Q2).

In addition, this arrangement ensures that the drain current $I_{DQ3}$ of the MOS field-effect transistor Q3 is dimensioned sufficiently high enough for discharging the gate-source capacitance $C_{GS1}$ so that during a time duration Dt the gate-source capacitance $C_{GS1}$ is discharged at least partly, preferably more or less completely.

Furthermore the rate of change of the gate voltage $V_{G2}$ of the low-side driver LSD (Q2) is selected smaller than that of the gate voltage $V_{G1}$ of the high-side driver HSD (Q1) to take into account that in the push-pull stage shown, i.e. comprising two MOS field-effect transistors Q1, Q2 connected in series with the output A inbetween, the high-side driver HSD (Q1) operates as a source follower whilst the low-side driver LSD (Q2) is a voltage amplifier so that when the high-side driver HSD (Q1) is switched the rate of change of the output voltage $U_a$ equals the rate of change of the corresponding gate voltage $V_{G1}$, whereas when the low-side driver LSD (Q2) is switched the rate of change of the output voltage $U_a$ is greater than that of the corresponding gate voltage $V_{G2}$. By the invention providing for correspondingly different rates of change in the gate voltages $V_{G1}$, $V_{G2}$ via the associated charging and discharge circuits L1, L2, E1, E2 this switching diffrerence between the high-side driver HSD (Q1) and the low-side driver LSD (Q2) is compensated.

In conclusion, the time duration Dt during which the gate-source capacitance $C_{GS1}$ of the high-side driver HSD (Q1) is discharged before the gate-source capacitance $C_{GS2}$ is charged is selected so that the wanted maximum rate of change of the output voltage $U_a$ is maintained. This time duration $D_t$ should thus not be smaller than the value dictated by the ratio of the maximum output voltage to the maximum rate of change. Together with the time constant of the charging circuit L1 of the low-side driver LSD (Q2) the difference between the threshold voltage $V_{T3}$ and the threshold voltage $V_{T2}$ of the low-side driver LSD (Q2) to be maintained can be determined.

In other words this difference in the threshold voltage $V_{T3}$-$V_{T2}$ is selected for instance as a function of the time constant of the charging circuit L2 of the low-side driver LSD (Q2) and of the time constant of the discharge circuit E1 formed by the inhibitor circuit or MOS field-effect transistor Q3 so that the gate-source capacitance $C_{GS1}$ of the high-side driver HSD (Q1) is discharged at least partly, preferably more or less completely as soon as the gate voltage $V_{G2}$ of the low-side driver LSD (Q2) has attained the threshold voltage $V_{T2}$ of the low-side driver LSD (Q2) after having exceeded the threshold voltage $V_{T3}$ of the MOS field-effect transistor (Q3).

Turning off the high-side driver HSD (Q1) and turning on the low-side driver LSD (Q2) thus occur in this circuit assembly as described in the following:

When the input voltage $U_{e2}$ is made to jump from a low level L to a high level H to turn on the low-side driver LSD (Q2) the gate voltage $V_{G2}$ of the low-side driver LSD (Q2) increases according to the time constant determined by the charging circuit L2 and the gate-source capacitance $C_{GS2}$. Since the threshold voltage $V_{T3}$ of the MOS field-effect transistor Q3 is smaller than the threshold voltage $V_{T2}$ of the low-side driver LSD (Q2) the MOS field-effect transistor Q3 is first rendered conducting, causing drain current $I_{DQ3}$ to flow in the discharge circuit E1. This results in the gate-source capacitance $C_{GS1}$ of the high-side driver HSD (Q1) being discharged via the drain-source connection D-S of the MOS field-effect transistor Q3. Following a further increase in the gate voltage $V_{G2}$ of the low-side driver LSD (Q2) according to the time constant determined by the charging circuit L2 and the gate-source capacitance $C_{GS2}$ the higher threshold voltage $V_{T2}$ of the low-side driver LSD (Q2) is then attained at which it starts to become conducting. At this point in time the gate-source capacitance $C_{GS1}$ of the high-side driver HSD (Q1) is however already partly, preferably more or less completely discharged.

Apart from one and the same MOS field-effect transistor Q3 serving both as an inhibitor and as a discharge element for the gate-source capacitance $C_{GS1}$ of the high-side driver HSD (Q1), thus achieving a simplified circuit configuration, this alternative circuit assembly also has the substantial advantage that due to eliminating the need to monitor the gate voltage $V_{G1}$ of the high-side driver HSD (Q1) it reliably excludes, by the simplest means, the possibility of an elevated gate voltage $V_{G1}$ being sensed - for example due to a noise voltage being introduced via the output A and the gate-source capacitance $C_{GS1}$ - which falsifies a charged gate-source capacitance $C_{GS1}$ or forward action of the high-side driver HSD (Q1) although in this case the source potential in actual fact is higher than the gate potential.

To achieve a higher drain current $I_{DQ3}$ for the discharge circuit E1 the Darlington circuit shown in Fig. 7 may also be effectively employed instead of the MOS field-effect transistor Q3. This Darlington circuit forming the corresponding inhibitor circuit Q3 comprises a MOS field-effect transistor Q3A and a bipolar npn transistor Q3B. In this arrangement the drain electrode D of the MOS field-effect transistor Q3A is connected to the collector of the bipolar transistor Q3B whilst its source electrode S is connected to the base of the bipolar transistor Q3B. Between base and emitter of the bipolar transistor Q3B a resistance R is inserted.

In this case a threshold voltage $V_{T3} = V_{T3A} + V_{be}$ results whereby $V_{T3A}$ is the threshold voltage of the MOS field-effect transistor Q3A and $V_{be}$ the base-emitter voltage of the bipolar transistor Q3B. When a transistor having a threshold voltage of more or less zero is employed as the transistor Q3A a resulting threshold voltage $V_{T3}$ appears which roughly corresponds to the base-emitter voltage of the bipolar transistor Q3B.

**Claims**

1. A circuit assembly for controlling a push-pull stage comprising at least two MOS field-effect transistors (Q1, Q2) including connectable charging and discharging circuits (L1, L2, E1, E2) by means of which the gate-source capacitances ($C_{GS1}$ , $C_{GS2}$ ) can be charged and discharged according to a corresponding time constant, the value of which is a function of the internal resistance of the corresponding charging and discharge circuit (L1, L2, E1, E2) respectively and of the corresponding gate-source capacitance ($C_{GS1}$ , $C_{GS2}$ ) **characterized by** at least one inhibitor circuit (Q3, Q4) being provided which is controlled by the gate voltage ($V_{G1}, V_{G2}$) of one of the MOS field-effect transistors (Q1, Q2), said inhibitor circuit preventing charging of the gate-source capacitance ($C_{GS1}$ , $C_{GS2}$ ) of the corresponding other MOS field-effect transistor (Q1, Q2) operating in push-pull until the gate voltage ($V_{G1}$ , $V_{G2}$ ) has exceeded a definable limit value at which the gate-source capacitance ($C_{GS1}$ , $C_{GS2}$ ) of the MOS field-effect transistor (Q1, Q2) monitored as regards its gate voltage ($V_{G1}$ , $V_{G2}$ ) has been discharged at least partly.

2. A circuit assembly as set forth in claim 1 **characterized by** the definable limit value for the monitored gate voltage ($V_{G1}$ , $V_{G2}$ ) being selected so that the gate-source capacitance ($C_{GS1}$ , $C_{GS2}$ ) of the corresponding MOS field-effect transistor (Q1, Q2) is discharged at least substantially when this limit value is no longer attained.

3. A circuit assembly as set forth in claim 1 or 2 **characterized by** the said inhibitor circuit being formed by at least one transistor, particularly a MOS field-effect transistor (Q3, Q4) the threshold value of which determines the definable limit value and the drain-source (D-S) connection of which in the forward mode prevents charging of the corresponding push-pull MOS field-effect transistor (Q1, Q2).

4. A circuit assembly as set forth in claim 3 **characterized by** the gate electrode (G) of the transistor (Q3, Q4) forming the inhibitor circuit being connected to the gate electrode (G) of the MOS field-effect transistor (Q1, Q2) monitored as regards its gate voltage ($V_{G1}$ , $V_{G2}$ ) and in that its drain-source connection (D-S) is connected between the gate electrode (G) of the other MOS field-effect transistor (Q1, Q2) operating in push-pull and ground GND (M) applied to one end of the push-pull stage.

5. A circuit assembly as set forth in any of the preceding claims **characterized by** each of the push-pull MOS field-effect transistors (Q1, Q2) being assigned an inhibitor circuit (Q3, Q4) to prevent charging of the gate-source capacitance ($C_{GS1}$ , $C_{GS2}$ ) of the other MOS field-effect transistor (Q1, Q2) operating in push-pull in each case as a function of its gate voltage ($V_{G1}$ , $V_{G2}$ ).

6. A circuit assembly as set forth in any of the claims 1 to 4 **characterized by** an inhibitor circuit (Q3) being assigned to only the MOS field-effect transistor (Q2) connected to ground GND (M) as the low-side driver (LSD) of the push-pull stage at a potential between that of the supply voltage (V$_{CC}$) and ground GND (M) to prevent charging of the gate-source capacitance (C$_{GS1}$) of the other MOS field-effect transistor (Q1) as the high-side driver (HSD) as a function of its gate voltage (V$_{G2}$) and in that said inhibitor circuit (Q3) simultaneously forms the discharge circuit (E1) of said high-side driver (HSD, Q1).

7. A circuit assembly as set forth in claim 6 **characterized by** an output terminal (A) on the one hand being connected to the drain electrode (D) of the low-side driver (LSD, Q2) and, on the other, the source electrode (S) of the high-side driver (HSD,Q2) being connected thereto, whilst said low-said driver (LSD, Q2) is connected by its source electrode (S) to ground GND (M) and the high-side driver (HSD, Q1) is connected by its drain electrode (D) to the supply voltage (V$_{CC}$).

8. A circuit assembly as set forth in claim 6 or 7 **characterized by** the threshold voltage (V$_{T3}$) of the inhibitor circuit (Q3) formed by at least one transistor being smaller than the threshold voltage (V$_{T2}$) of the low-side driver (LSD, Q2).

9. A circuit assembly as set forth in any of the claims 6 to 8 **characterized by** the rates of change of the gate voltages (V$_{G1}$, V$_{G2}$) of the high-side driver (HSD, Q1) and of the low-side driver (LSD, Q2) as determined by the corresponding charging and discharging circuits (L1, L2, E1, E2) and the associated gate-source capacitance (C$_{GS1}$, C$_{GS2}$) being different, whereby the rate of change of the gate voltage (V$_{G2}$) of the low-side driver (LSD, Q2) is smaller than that of the gate voltage (V$_{G1}$) of the high-side driver (HSD, Q1).

10. A circuit assembly as set forth in claim 8 and 9 **characterized by** the difference between the two threshold voltages (V$_{T2}$, V$_{T3}$) being selected as a function of the time constant of the charging circuit (L2) of the low-side driver (LSD, Q2) and of the time constant of the discharge circuit (E1) formed by the inhibitor circuit (Q3) so that the gate-source capacitance (C$_{GS1}$) of the high-side driver (HSD, Q1) is discharged at least partly as soon as the gate voltage (V$_{G2}$) of the low-side driver (LSD, Q2) controlling said inhibitor or discharge circuit (Q3, E1) has attained the threshold voltage (V$_{T2}$) of the low-side driver (LSD, Q2) after having exceeded the threshold voltage (V$_{T3}$) of said inhibitor or discharge circuit (Q3, E1).

11. A circuit assembly as set forth in claim 10 **characterized by** the difference in the threshold voltages (V$_{T2}$ -V$_{T3}$) being selected so that the gate-source capacitance (C$_{GS1}$) of the high-side driver (HSD, Q1) is discharged at least substantially when the threshold voltage (V$_{T2}$) of the low-side driver (LSD, Q2) is attained.

12. A circuit assembly as set forth in any of the claims 6 to 11 **characterized by** the inhibitor circuit (Q3) containing a Darlington circuit (Q3A, Q3B).

# Fig. 1

# Fig. 2

# Fig. 3

# Fig. 4

# Fig. 5

# Fig. 6

# Fig. 7

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | US-A-5 159 515 (J. FISHBEIN)<br><br>* abstract; figure 1 *<br>* column 2, line 59 - column 3, line 25; claims 1,7,8 *<br>--- | 1,3,4,6, 7 | H03K17/16<br>H03K17/687<br>H03K17/08 |
| X | US-A-5 155 398 (A. MIKUNI ET AL.)<br>* abstract; figure 1 *<br>* column 2, line 32 - column 3, line 58; claims 1-4 *<br>--- | 1,5 | |
| X | PATENT ABSTRACTS OF JAPAN<br>vol. 17, no. 32 (E-1309) 21 January 1993<br>& JP-A-04 253 418 (NEC CORP) 9 September 1992<br>* abstract *<br>--- | 1,3-5 | |
| X | PATENT ABSTRACTS OF JAPAN<br>vol. 017, no. 234 (E-1362) 12 May 1993<br>& JP-A-04 362 811 (NEC CORP) 15 December 1992<br>* abstract *<br>----- | 1,5 | TECHNICAL FIELDS SEARCHED (Int.Cl.5)<br><br>H03K |

The present search report has been drawn up for all claims

| Place of search | Date of completion of the search | Examiner |
|---|---|---|
| BERLIN | 17 October 1994 | Arendt, M |

EPO FORM 1503 03.82 (P04C01)